# FASCICULE DE BREVET EUROPEEN

(11) **EP 0 609 113 B1**
(45) Date de publication et mention de la délivrance du brevet: **28.10.1998**
(21) Numéro de dépôt: 94400092.6
(22) Date de dépôt: 14.01.1994
(51) Int. Cl.: G01R 19/18, G01R 31/36

(54) **Dispositif de mesure d'un paramètre électrique continu, tel qu'une tension**
Vorrichtung zur Messung einer elektrischen Gleichstromgrösse, beispielsweise einer Spannung
Device for measuring an electric DC-parameter, like a voltage

(30) Priorité: 22.01.1993 FR 9300657
(43) Date de publication de la demande: 03.08.1994
(73) Titulaire: AUTOMOBILES PEUGEOT, 75116 Paris (FR); AUTOMOBILES CITROEN, 92200 Neuilly-sur-Seine (FR)
(72) Inventeur: Duday, Jean-Michel, F-95150 Taverny (FR)
(74) Mandataire: Pinchon, Odile

(56) Documents cités:
- EP-A- 0 280 916
- DE-A- 1 591 942
- DE-A- 1 591 964
- DE-A- 3 041 196

## Description

La présente invention concerne un dispositif de mesure d'un paramètre électrique continu tel qu'une tension.

Le dispositif selon l'invention peut par exemple être utilisé dans des véhicules mus par l'énergie d'une source électrique embarquée dans lesquels une mesure précise de la tension de la batterie d'alimentation en énergie est nécessaire pour la gestion du fonctionnement de celui-ci.

La batterie d'un tel véhicule est réalisée par exemple par connexion en série d'un grand nombre d'éléments indépendants et une mesure globale de tension ne peut suffire à détecter un élément défectueux.

On doit donc alors s'attacher à mesurer la tension délivrée par chaque sous-groupe d'éléments de batterie.

Cependant, les tensions utilisées dans ce type d'applications sont relativement élevées et dangereuses pour les utilisateurs, de sorte que des régles de sécurité amènent à prévoir une isolation galvanique entre la batterie et certains organes fonctionnels du véhicule.

On conçoit alors que la mesure de telles tensions ne peut être réalisée qu'au travers d'une barrière d'isolation galvanique.

En régle générale, une isolation galvanique peut être obtenue en utilisant des moyens de couplage de différents types.

C'est ainsi par exemple que des moyens de couplage optique utilisant des opto-coupleurs, des moyens de couplage inductif utilisant des transformateurs, des moyens de couplage magnétique utilisant des capteurs à effet Hall et des moyens de couplage capacitif utilisant des liaisons par condensateurs, ont été utilisés dans l'état de la technique.

Plus particulièrement, certains de ces moyens ont été utilisés pour réaliser des moyens de mesure de tension.

C'est ainsi par exemple qu'on connaît des dispositifs de mesure de tension comportant des capteurs à effet Hall, qui sont bien adaptés à la mesure de très hautes tensions, mais qui présentent différents inconvénients parmi lesquels une forte consommation d'énergie, une sensibilité à la température et un encombrement et un coût relativement élevés.

On a également utilisé dans l'état de la technique des amplificateurs d'isolation intégrés de différentes sortes, reposant sur l'utilisation de moyens d'isolation optiques, inductifs ou encore capacitifs. Cependant, ces composants sont d'un prix relativement élevé, et nécessitent en outre des alimentations isolées additionnelles.

On a également utilisé dans l'état de la technique, des convertisseurs analogiques-numériques, mais ceux-ci sont également relativement coûteux et n'apportent pas de solution au problème d'isolation galvanique mentionné précédemment.

Enfin, on connaît, par exemple par le document DE-A-1591942, un dispositif de mesure d'un paramètre électrique continu tel qu'une tension, comprenant une source de signal d'alimentation à haute fréquence raccordée au primaire d'un transformateur d'isolation galvanique, des moyens de modulation raccordés au secondaire du transformateur, alimentés à partir du signal à haute fréquence recevant le paramètre à mesurer et adaptés pour superposer sur le signal à haute fréquence un signal de modulation représentatif du paramètre à mesurer.

Dans ce dispositif, le transformateur est utilisé dans un convertisseur de tension piloté par un signal rectangulaire. La tension à mesurer est, par l'intermédiaire d'une diode, montée en opposition avec la tension délivrée par ce convertisseur. Ce dernier fonctionne à vide tant que sa tension est inférieure à la tension à mesurer, puis en charge. Il en résulte une variation, mesurable au secondaire, de son courant absorbé, cette variation servant à mesurer la tension primaire.

Cependant, dans ce dispositif, le transformateur fait partie de la chaîne de mesure, c'est-à-dire que ses caractéristiques ou les variations de celles-ci sous l'influence par exemple de la température, interviennent sur la valeur mesurée et la diode utilisée au primaire induit une erreur significative dans les mesures, dès lors que la tension à mesurer n'est pas grande par rapport à sa tension de seuil.

Le but de l'invention est donc de résoudre ces problèmes, en proposant un dispositif de mesure qui soit simple, fiable, qui présente une bonne tenue en tension d'isolation, une consommation d'énergie la plus réduite possible, une bonne précision, une faible dérive en température, une aptitude au fonctionnement en milieu perturbé et qui soit d'un coût et d'un encombrement relativement faibles.

A cet effet, l'invention a pour objet un dispositif de mesure d'un paramètre électrique continu tel qu'une tension comportant une source de signal d'alimentation à haute fréquence, raccordée au primaire d'un transformateur d'isolation galvanique, des moyens de modulation raccordés au secondaire du transformateur, alimentés à partir du signal à haute fréquence, recevant le paramètre à mesurer et adaptés pour superposer sur le signal à haute fréquence, un signal de modulation représentatif du paramètre à mesurer, qui comporte en outre des moyens de détermination du paramètre à mesurer à partir du signal de modulation, raccordés au primaire du transformateur, et que les moyens de modulation comprennent un convertisseur tension-fréquence dont l'entrée reçoit le paramètre à mesurer et dont la sortie pilote des moyens de charge du secondaire du transformateur et que les moyens de charge comprennent un transistor connecté aux bornes du secondaire du transformateur.

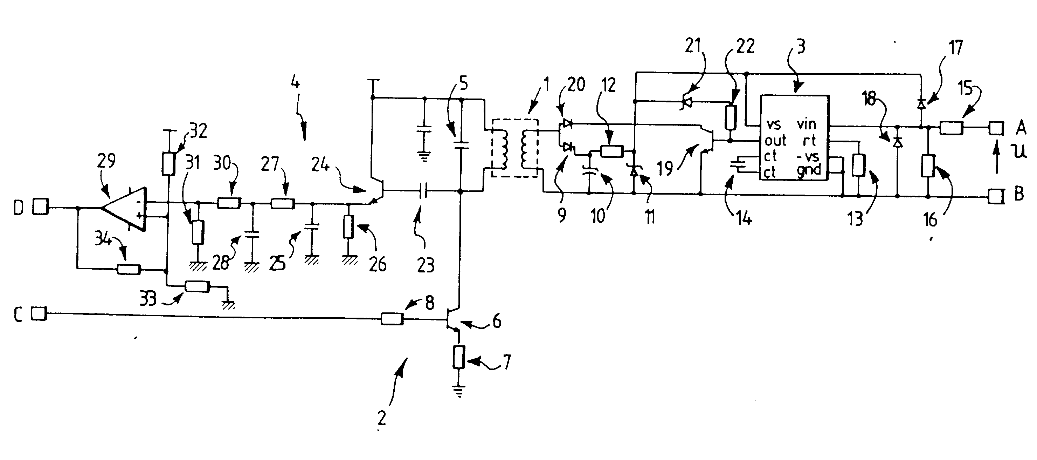

L'invention sera mieux comprise à l'aide de la description qui va suivre, donnée uniquement à titre d'exemple et faite en se référant au dessin annexé, qui représente un schéma électrique d'un dispositif de mesure selon l'invention.

Ainsi qu'on peut le voir sur cette figure, un dispositif de mesure selon l'invention permet de réaliser la mesure d'un paramètre électrique continu tel qu'une tension U présente entre des bornes désignées par les références A et B sur cette figure.

Ce dispositif comporte un transformateur d'isolation galvanique à haute fréquence désigné par la référence générale 1 sur cette figure.

Ce dispositif comporte également une source de signal d'alimentation à haute fréquence désignée par la référence générale 2 sur cette figure et raccordée au primaire du transformateur, des moyens de modulation 3 raccordés au secondaire du transformateur, alimentés à partir du signal à haute fréquence mentionné précédemment, recevant le paramètre U à mesurer et adaptés pour superposer sur le signal à haute fréquence, un signal de modulation représentatif de ce paramètre.

Enfin, le dispositif selon l'invention comporte également des moyens 4 de détermination du paramètre à partir du signal de modulation, raccordés au primaire du transformateur.

On conçoit alors que le dispositif selon l'invention utilise un seul transformateur d'isolation galvaà haute fréquence assurant à la fois dans un sens le transfert de puissance permettant l'alimentation d'une circuiterie électronique isolée de mesure du paramètre et dans l'autre sens la transmission des informations représentatives de celui-ci.

Cette mesure repose sur une conversion tension/fréquence par utilisation d'un oscillateur commandé par tension délivrant un signal dont la fréquence est directement liée au paramètre, c'est à dire par exemple à la tension à mesurer.

Le signal délivré par cet oscillateur fait varier périodiquement une charge au secondaire du transformateur et le signal à haute fréquence présent aux bornes du primaire du transformateur se trouve ainsi modulé en amplitude.

Après détection et filtrage de ce signal, on obtient un signal périodique dont la fréquence est l'image de la tension mesurée.

Si l'on se reporte plus en détail à la figure, on peut constater que le primaire du transformateur 1, accordé par un condensateur 5 connecté aux bornes de celui-ci, est alimenté par une source de courant pulsée à sa fréquence d'accord, par exemple 750 kHertz, pour engendrer une tension au secondaire du transformateur.

Cette source de courant désignée par la référence générale 2 comporte un transistor NPN 6 et une résistance 7, connectés en série entre une borne du primaire du transformateur et la masse. L'autre borne du primaire du transformateur est reliée à la borne positive d'une alimentation.

La base de ce transistor 6 reçoit un signal en créneaux appliqué sur une borne d'entrée C du dispositif, à travers une résistance de polarisation 8. Ce signal en créneaux est engendré par tout circuit approprié de type classique.

La tension résultante présente au secondaire du transformateur 1 est tout d'abord redressée par une diode 9, filtrée par un condensateur 10 et stabilisée par une diode Zener 11 associée à une résistance 12.

Ces différents moyens constituent des moyens d'alimentation d'un oscillateur commandé par tension VCO formant les moyens de modulation désignés par la référence générale 3 sur cette figure et sont interposés entre le secondaire du transformateur et cet oscillateur.

Cet oscillateur est par exemple constitué par un circuit intégré dont la fréquence d'oscillation de sortie est déterminée par une résistance 13 et un condensateur 14 et le paramètre à mesurer formé par exemple par la tension U présente entre les bornes A et B.

Cette tension est en effet appliquée à la borne d'entrée de commande de cet oscillateur commandé par tension, après passage dans un pont diviseur constitué par des résistances 15 et 16.

Des diodes 17 et 18 sont destinées à protéger cette entrée de l'oscillateur contre d'éventuelles surtensions.

La borne de sortie de cet oscillateur est reliée à la base d'un transistor NPN 19, constituant la charge mentionnée précédemment, dont le circuit collecteur-émetteur est relié en parallèle entre les bornes du secondaire du transformateur 1 à travers une diode 20.

Afin de garantir le démarrage du circuit, une diode Zener 21 en série avec une résistance 22, sont connectées entre la base du transistor 19 et la borne d'alimentation de l'oscillateur pour empêcher toute conduction de ce transistor 19 tant que la tension d'alimentation disponible pour cet oscillateur n'est pas suffisante.

On conçoit que cette partie de circuit permet de superposer sur le signal d'alimentation à haute fréquence, un signal de modulation en amplitude dont la fréquence est représentative du paramètre et plus particulièrement de la tension à mesurer.

La tension présente au primaire du transformateur, c'est à dire sur le collecteur du transistor 6, est appliquée à travers un condensateur 23 à la base d'un transistor NPN 24 utilisé comme démodulateur.

Le collecteur de celui-ci est relié à la borne positive de l'alimentation et est découplé à la masse à travers un condensateur.

On obtient alors aux bornes d'un condensateur 25 et d'une résistance 26 connectés en parallèle entre l'émetteur de ce transistor 24 et la masse, un signal à la fréquence du signal de sortie de l'oscillateur sur lequel est superposée une composante à haute fréquence.

Un filtre passe-bas connecté à ce condensateur 25 et comportant une résistance 27 et un condensateur 28, permet d'obtenir une réjection de la composante à haute fréquence de ce signal, pour ne laisser passer que la composante à la fréquence de sortie de l'oscillateur.

La sortie de ce filtre est reliée à la borne non inverseuse d'un amplificateur opérationnel monté en comparateur 29, à travers un pont diviseur comportant des résistances 30 et 31.

L'entrée inverseuse de cet amplificateur opérationnel reçoit une tension de référence délivrée par un pont diviseur comportant des résistances 32 et 33.

La sortie de cet amplificateur opérationnel 29 est rebouclée sur son entrée non inverseuse à travers une résistance 34.

Ce comparateur permet de remettre en forme le signal de manière à délivrer sur une borne D de sortie du dispositif, un signal en créneaux, par exemple compatible TTL, à la fréquence du signal délivré par l'oscillateur 3, c'est à dire un signal représentatif du paramètre à mesurer, ce signal pouvant ensuite être traité par une électronique numérique standard pour déterminer la valeur du paramètre mesuré.

Bien que dans l'exemple de réalisation, on ait décrit un oscillateur commandé par tension pour réaliser la mesure et il va de soi bien entendu que celle-ci peut également être réalisée avec d'autres types de convertisseurs analogiques-numériques, par exemple du type à approximations successives.

On conçoit alors que le dispositif selon l'invention présente une consommation négligeable sur la tension à mesurer ce qui permet de le maintenir connecté en permanence sur cette tension.

Par ailleurs, ce dispositif présente également une bonne isolation galvanique et une grande robustesse vis à vis des surtensions et des inversions de polarité.

Enfin, le dispositif selon l'invention est d'un coût faible et d'un encombrement réduit, ceci en raison notamment de l'absence d'alimentation additionnelle.

## Revendications

1. Dispositif de mesure d'un paramètre électrique continu tel qu'une tension comportant une source (2) de signal d'alimentation à haute fréquence, raccordée au primaire d'un transformateur d'isolation galvanique (1), des moyens de modulation (3) raccordés au secondaire du transformateur (1), alimentés à partir du signal à haute fréquence, recevant le paramètre (U) à mesurer et adaptés pour superposer sur le signal à haute fréquence, un signal de modulation représentatif du paramètre à mesurer, caractérisé en ce qu'il comporte en outre des moyens (4) de détermination du paramètre à mesurer à partir du signal de modulation, raccordés au primaire du transformateur, et que les moyens de modulation comprennent un convertisseur tension-fréquence (3) dont l'entrée reçoit le paramètre à mesurer et dont la sortie pilote des moyens de charge (19) du secondaire du transformateur et que les moyens de charge comprennent un transistor (19) connecté aux bornes du secondaire du transformateur.

2. Dispositif selon la revendication 1, caractérisé en ce que la source (2) de signal à haute fréquence d'alimentation comporte une source de courant pilotée par un signal à la fréquence d'accord du transformateur.

3. Dispositif selon l'une quelconque des revendications précédentes, caractérisé en ce que des moyens (9,10,11,12) de conversion du signal d'alimentation à haute fréquence en signal d'alimentation à peu près continu, sont interposés entre le secondaire du transformateur (1) et les moyens de modulation (3).

4. Dispositif selon la revendication 3, caractérisé en ce que les moyens de conversion comprennent des moyens de redressement (9), des moyens de filtrage (10) et des moyens de stabilisation de tension (11,12).

5. Dispositif seîon l'une quelconque des revendications précédentes, caractérisé en ce que les moyens de détermination comprennent des moyens (24,25,26) de démodulation dont la sortie est reliée à l'entrée d'un filtre passe-bas (27,28) dont la sortie est elle-même reliée à l'entrée de moyens de remise en forme (29) dont la sortie délivre un signal de mesure à la fréquence du signal délivré par les moyens de modulation (3).

6. Dispositif selon la revendication 5, caractérisé en ce que les moyens de remise en forme comprennent un amplificateur opérationnel (29).

## Patentansprüche

1. Vorrichtung zur Messung einer elektrischen Gleichstromgröße wie einer Spannung, mit einer Quelle (2) eines hochfrequenten Versorgungssignals, die an die Primärseite eines Transformators zur galvanischen Isolierung (1) angeschlossen ist, einer an die Sekundärseite des Transformators (1) angeschlossenen Modulationseinrichtung (3), die von dem hochfrequenten Signal versorgt wird, den zu messenden Parameter (U) erhält und dazu ausgelegt ist, dem hochfrequenten Signal ein für den zu messenden Parameter repräsentatives Modulationssignal zu überlagern, dadurch gekennzeichnet, daß sie außerdem eine Einrichtung (4) zur Bestimmung des zu messenden Parameters über das Modulationssignal aufweist, die an die Primärseite des Transformators angeschlossen ist, und dadurch, daß die Modulationseinrichtung einen Spannungs-Frequenz-Umsetzer (3) umfaßt, der am Eingang den zu messenden Parameter aufnimmt und dessen Ausgang eine Lasteinrichtung (19) der Sekundärseite des Transformators steuert, und dadurch, daß die Lasteinrichtung einen Transistor (19) umfaßt, der mit den Anschlüssen der Sekundärseite des Transformators verbunden ist.

2. Vorrichtung nach Anspruch 1, dadurch gekennzeichnet, daß die Quelle (2) des hochfrequenten Versorgungssignals eine Stromquelle umfaßt, die durch ein Signal mit einer auf den Transformator abgestimmten Frequenz gesteuert wird.

3. Vorrichtung nach einem der vorhergehenden Ansprüche, dadurch gekennzeichnet, daß die Einrichtung (9, 10, 11, 12) zur Umwandlung des hochfrequenten Versorgungssignals in ein annähernd kontinuierliches Signal zwischen die Sekundärseite des Transformators (1) und die Modulationseinrichtung (3) geschaltet ist.

4. Vorrichtung nach Anspruch 3, dadurch gekennzeichnet, daß die Umwandlungseinrichtung eine Gleichrichteinrichtung (9), eine Filtereinrichtung (10) und eine Spannungsstabilisierungseinrichtung (11, 12) aufweist.

5. Vorrichtung nach einem der vorhergehenden Ansprüche, dadurch gekennzeichnet, daß die Bestimmungseinrichtung eine Demodulationseinrichtung (24, 25, 26) aufweist, deren Ausgang mit dem Eingang eines Tiefpaßfilters (27, 28) verbunden ist, dessen Ausgang mit dem Eingang einer Aufbereitungseinrichtung (29) verbunden ist, deren Ausgang ein Meßsignal mit der Frequenz des von der Modulationseinrichtung (3) gelieferten Signals liefert.

6. Vorrichtung nach Anspruch 5, dadurch gekennzeichnet, daß die Aufbereitungseinrichtung einen Operationsverstärker (29) aufweist.

## Claims

1. Device for measuring a continuous electrical parameter such as voltage, comprising a source (2) of high-frequency supply signal, connected to the primary of a galvanic isolation transformer (1), modulation means (3) connected to the secondary of the transformer (1), supplied from the high-frequency signal, receiving the parameter (U) to be measured and adapted to superimpose on the high-frequency signal a modulation signal representing the parameter to be measured, characterised in that it further comprises means (4) for determining the parameter to be measured on the basis of the modulation signal, connected to the primary of the transformer, and that the modulation means comprise a voltage-to-frequency converter (3), the input of which receives the parameter to be measured and the output of which controls means (19) for charging the secondary of the transformer and that the charging means comprise a transistor (19) connected to the terminals of the secondary of the transformer.

2. Device according to Claim 1, characterised in that the source (2) of high-frequency supply signal comprises a current source controlled by a signal at the tuning frequency of the transformer.

3. Device according to any one of the preceding claims, characterised in that means (9, 10, 11, 12) for converting the high-frequency supply signal into a substantially continuous supply signal are interposed between the secondary of the transformer (1) and the modulation means (3).

4. Device according to Claim 3, characterised in that the conversion means comprise rectifying means (9), filtering means (10) and voltage-stabilisation means (11, 12).

5. Device according to any one of the preceding claims, characterised in that the determination means comprise demodulation means (24, 25, 26), the output of which is connected to the input of a low-pass filter (27, 28), the output of which is itself connected to the input of reshaping means (29), the output of which delivers a measurement signal at the frequency of the signal delivered by the modulation means (3).

6. Device according to Claim 5, characterised in that the reshaping means comprise an operational amplifier (29).
